Europäisches Patentamt

European Patent Office (11) Publication number: **0 150 941**

Office européen des brevets **A1**

(12) **EUROPEAN PATENT APPLICATION**

(21) Application number: **85300211.1**

(22) Date of filing: **11.01.85**

(51) Int. Cl.⁴: **H 01 J 37/10, H 01 J 27/00**

(30) Priority: **19.01.84 GB 8401471**

(43) Date of publication of application: **07.08.85**
**Bulletin 85/32**

(84) Designated Contracting States: **AT BE CH DE FR GB IT LI LU NL SE**

(71) Applicant: **DUBILIER PLC, Dubilier House Radley Road, Abingdon Oxford OX14 3XA (GB)**

(72) Inventor: **Cleaver, John Richard Adrian Dept. of Engineering, Cambridge University Trumpington Street, Cambridge CB2 1PZ (GB)**
Inventor: **Ahmed, Haroon Dept. of Engineering, Cambridge University Trumpington Street, Cambridge CB2 1PZ (GB)**

(74) Representative: **Boydell, John Christopher et al, Stevens, Hewlett & Perkins 5 Quality Court Chancery Lane, London, WC2A 1HZ (GB)**

(54) **Charged-particle optical systems.**

(57) A charged particle optical system for producing focused beams of both ions and electrons and comprising an electrostatic objective lens situated symmetrically about an axis 4 and with outer electrodes 1, 2 and an inner electrode 3. The lens electrode potentials and the energies of the respective particles entering the lens along the axis are adjusted in such a way as to focus both the ion and electron beams onto a common target plane.

A

"CHARGED-PARTICLE OPTICAL SYSTEMS"

This invention relates to charged-particle optical systems for the production of finely-focused beams of both electrons and ions.

Scanning electron beam instruments, in which a finely-focused beam of electrons is deflected across a target for the purpose either of forming an image of it or of modifying it, are well established. The earliest instrument in this category was the scanning electron microscope, which can form images from the surface of solid specimens (see Smith and Oatley, 1955 Brit. J. Appl. Phys. $\underline{6}$, 391-399) or in transmission from thin specimens (see Crewe et al., 1968 J. Appl. Phys. $\underline{39}$, 5861-5868). Solid specimens can be imaged with resolution better than 5 nm, and transmission specimens better than 0.5 nm. From the microscopes have evolved scanning electron beam microfabrication instruments, used for producing patterns for microelectronic device fabrication. In these instruments the finely focused electron beam is deflected under computer control over an electron-sensitive resist layer deposited on the surface either of a mask plate or of a partially-fabricated semiconductor device wafer to enable the resist layer subsequently to be selectively dissolved, forming a pattern that defines the areas to be subjected to a subsequent process such as etching or ion implantation.

It is possible to construct a similar range of instruments which use ion beams rather than electron beams. However, traditional gas-discharge ion sources are too large and produce too small a current density for use as a basis for scanning ion beam systems with focused beams of comparable diameters and currents to those available in electron beam systems. The recently invented liquid-metal field-ionisation source (see Clampitt et al., 1975 J. Vac. Sci. Technol. $\underline{12}$, 1208),

which has relatively a very small size and high brightness, has made possible the production of sub-micron diameter ion beams that can transport useful ion currents. The resultant scanning ion beam systems can, like electron beams, be used both for imaging and for microfabrication; the scanning ion microscope (see Cleaver, 1983 EMAG 83 Inst. Phys. Conf. Ser.) can perform imaging in modes not available in the electron microscope (see Levi-Setti et al., 1983 Nucl. Instrum. and Meth. 205, 299-309), whilst scanning ion beam lithography instruments can not only pattern resist layers but can also be used for direct maskless ion implantation of dopants and for micromachining operations (see Cleaver et al., 1983 "Microcircuit Engineering 83", Academic Press; and Wagner, 1983 Solid State Technol., May 1983, 97-103).

Both in microscopes and in microcircuit fabrication instruments it is advantageous for finely focused beams of both ions and electrons to be present either simultaneously or in rapid sequence. In microscopes comparisons can be made between the information derived in various image formation modes using the scanned electron and ion beams, whilst in microcircuit fabrication the two focused beams can be used for different aspects of processing, for example using the scanned electron beam to detect fiducial marks for pattern registration and then using the ion beam for implantation or micromachining. For these purposes it is necessary to form sub-micron diameter beams of ions and electrons lying, in the absence of deflection scanning signals, on the same axis. Electrons can be focused with either electrostatic or magnetic lenses, but the relatively large mass-to-charge ratio of ions necessitates the use of electrostatic lenses. Objective lenses (the final lenses which form the finely focused beams at the target) need to have short working distances of only a few millimetres, in order to achieve good optical performance, and thus it is not practicable to consider having two lenses with different oblique axes converging onto the target. Oblique incidence would also introduce very severe problems in matching the scan fields covered by the deflected ion and electron beams.

Therefore a combined beam system requires coaxial objective lenses for the ions and for the electrons. The present invention seeks to achieve this result by using a common lens for both the ions and the electrons.

In accordance with the invention there is provided a charged-particle optical system for the production of finely-focused beams of both electrons and ions, said system comprising a source of electrons, a source of ions and a single electrostatic objective lens comprising at least two electrodes arranged along an optical axis, the lens electrode potentials and the energies of the particles entering the lens being such as to cause the lens to focus both the ion and electron beams onto a common target plane coincident with the target.

It will be seen that the optical system of the invention can be used in applications where a beam of electrons or a beam of positively or negatively charged ions need to be focused onto a target either one at a time by choice, or under automatic control for example alternately in sequence, or both ions and electrons simultaneously. In one embodiment, the electrostatic lens has three or more electrodes in which the outermost electrodes are at the same potential (commonly, but not necessarily, ground potential) so that both kinds of particle emerge from the lens with energies unchanged from their values at incidence. It is in general necessary for the ion and the electron beams to have been accelerated through different voltages prior to entering the lens, to compensate for the different focal properties of the lens for charged particles of opposite polarities. A specific instance of this kind of lens is the three-element einzel lens, in which one kind of particle is accelerated on entering the lens and is then decelerated, whilst the other kind is initially decelerated. This will be explained in more detail hereinafter. For ions and electrons entering at the same voltage, the initially-decelerating mode of operation gives stronger focal properties; thus, for the two beams to be brought to focus in the same plane, the particles that are to be subject to initial deceleration must enter the lens with a higher voltage.

In an alternative embodiment the electrostatic lens has three or more electrodes, with the outermost at different potentials. There is thus net acceleration of one kind of particle and net deceleration of the other kind in passage through the lens, whilst within the lens one kind of particle is initially accelerated and then decelerated and the other kind is initially decelerated and then accelerated. A degenerate form of this system would have two electrodes only, so that one kind of particle would be accelerated monotonically and the other decelerated monotonically.

In a preferred embodiment, the ion and electron beams that enter the objective lens are produced by separate charged-particle optical columns and are combined by a deflecting prism, composed of electric or magnetic fields (or a combination of both electric and magnetic fields) preceding the objective lens. The prism fields can be adjusted to direct either the electron beam and the ion beam alone or in sequence, or both of those beams simultaneously, into the objective lens.

In order that the invention may be better understood, an embodiment thereof will now be described by way of example only and with reference to the accompanying drawings in which:-

Figure 1A is a diagrammatic side view of a known three-element einzel lens;

Figures 1B and C show graphically two possible variations of potential along the axis of the lens of Figure 1A;

Figure 1D is a diagram of the electron trajectory through the lens of Figure 1A;

Figure 2A is a view similar to that of Figure 1A but showing the manner in which the ion and electron beams may be brought to a common focus in accordance with the present invention;

Figure 2B is similar to Figure 1B, but shows the respective potentials necessary to achieve the trajectories shown in Figure 2A;

Figure 3 is a diagrammatic side view of a complete optical system constructed in accordance with the invention;

Figure 4 is a diagrammatic side view of the beam combiner forming part of the system of Figure 3; and

Figures 5 to 8 show diagrammatically various alternative methods of combining the beams.

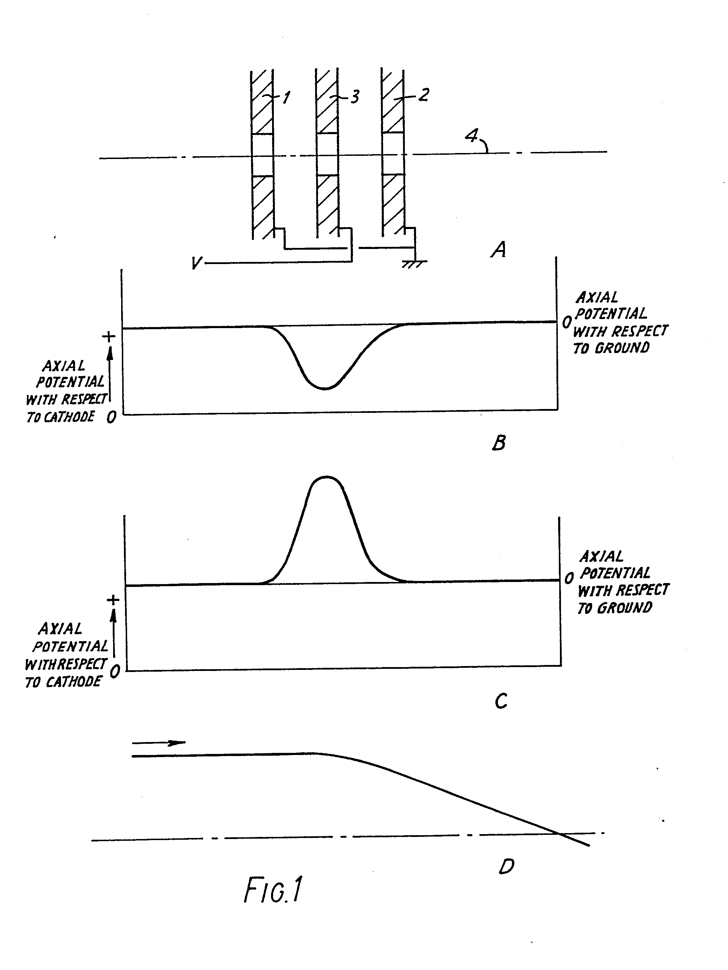

The three-element electrostatic einzel-lens shown in Figure 1A consists of two outer electrodes 1,2 at the same electric potential (normally ground potential) and a central electrode 3 at an elevated potential V. All electrodes have round holes on the system axis 4, about which there is cylindrical symmetry. The lens can be operated in two modes: in Figure 1B the central electrode is at a potential which lies between that of the outer electrodes and that of the source of charged particles (not shown) so that in passage through the lens they are initially decelerated and subsequently accelerated back to their initial velocity; in Figure 1C the outer electrodes are shown at a potential between that of the source and that of the central electrode so that the particles are first accelerated and then decelerated. The arrangements are shown with polarity suitable for electrons, for which a typical trajectory is shown in Figure 1D. The potentials required for focusing are rather different in the two modes: in the initially-decelerating mode the particles are retarded by about 80% of the full beam potential whilst in the initially-accelerating mode they are accelerated by about 150% of the beam potential.

Similar optical characteristics can be produced with lenses whose outer electrodes are not at the same potential, so that there is net acceleration or deceleration for charged particles that pass through the lens. In some cases a degenerate form of lens with only two electrodes can be employed. More than three electrodes can be employed to produce the necessary electric field without affecting the principle of the system.

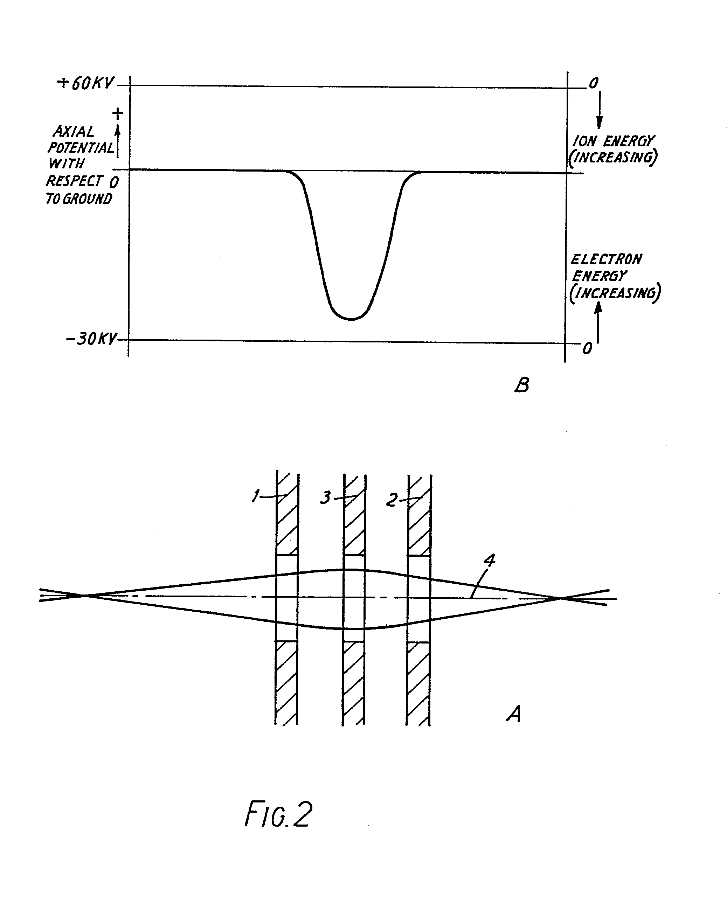

If the same lens is used both for positive ions and for electrons, then for one set of particles it will act as an initially-accelerating lens whilst for the other set it will act as an initially-decelerating lens. If the ion and the electron beams have been accelerated through equal potential differences before reaching the lens, then the lens will have different focal lengths for the ions and for the electrons (for a parallel incident beam the initially-decelerated particles will be brought to a focus much closer to the lens than the initially-accelerated particles). However, in the dual-beam instruments there is often no need for the beam potentials to be equal; with beam potentials in an approximately 2:1 ratio the correct optical conditions can be achieved. For example, consider the lens shown in Figure 2 with a central electrode 3 potential of + 45kV and outer electrodes 1,2 grounded. For a beam of electrons from a cathode at -30kV the lens would serve as an initially-accelerating lens (accelerating the electrons to about 75kV) whilst for a beam of ions from a source at +60kV the lens would serve as an initially-decelerating lens (decelerating the ions to about 15kV). These lenses would have approximately the same strength; adjustment of the potential of one beam would bring the focal planes for both the electrons and the ions into coincidence. The potential distribution on the axis of the lens is shown in Figure 2B, together with the variation of ion and electron energies in passage through the lens; Figure 2A shows the resultant ion and electron trajectories. It will be noted that the ions and the electrons, whilst having the same foci outside the lens, will not necessarily have identical trajectories within the lens electric field.

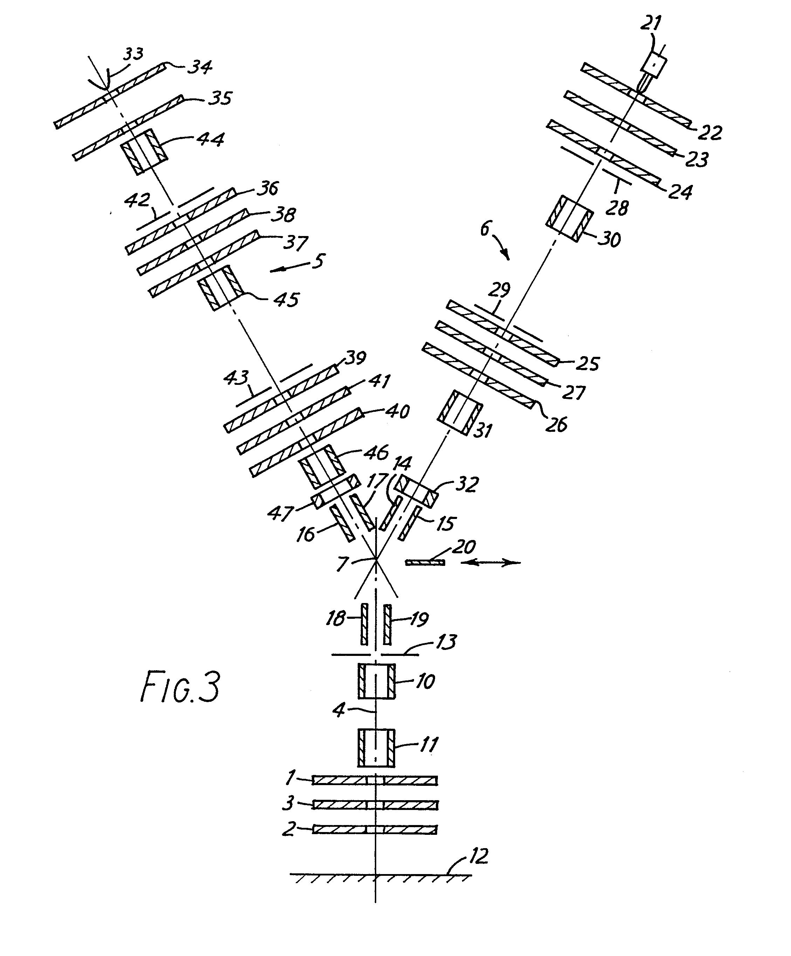

The dual-function objective lens is shown incorporated in a complete optical system in Figure 3. The source of electrons comprises an electron gun having a cathode 33, Wehnelt electrode 34 and anode 35, and an electron optical column shown generally under reference 5. The source of ions comprises an ion gun having a liquid metal ion source 21, emission control electrode 22, accelerator electrodes 23,24, and an ion optical column shown generally under reference 6. The axes of the respective optical columns cross at point 7 where the respective beams are deflected and combined, as will be explained, onto the axis 4 of the einzel lens 1,2,3. The lens 1,2,3 acts to bring the ion and electron beams to a common focus on a target plane 12. The detailed description is written on the assumption that the axis 4 of the objective lens is vertical, and that the target is below the objective lens. This accords with common (but not invariable) practice in electron beam and in ion beam systems, and is adopted for convenience: it is not fundamental to system operation.

Above the lens electrodes 1,2 and 3 are electric scanning plates arranged in upper and lower plate sets 10,11, each consisting of quadrupole or octopole electrode arrays. These act as a double-deflector to rock the charged-particle beams about the centre of the lens, deflecting the beam at the target 12 whilst keeping the lens aberrations small. Different deflector plate potentials are required for ions and for electrons if the same scanned field is to be covered, but this can readily be achieved with a computer-controlled scan signal generator. Above the deflector set is an aperture stop 13 that determines the current that passes into the final lens, and above that is a deflecting prism system consisting of electric deflector plates 14-19 that can select either the ion or the electron beam to pass into the final lens.

The ion and the electron beams that enter the deflecting prism system are produced by the optical columns 5,6 which are composed of conventional elements. The ion gun is of tetrode form and comprises a liquid-metal ion source 21, an emission control electrode 22, and two accelerator electrodes 23,24. A three-element einzel lens comprising electrodes 25 to 27 acts as an intermediate condenser lens. The electron gun, with cathode 33, Wehnelt 34 and anode 35 is followed by two three-element einzel lenses 36 to 38 and 39 to 41 as condenser lenses. Both columns incorporate additional electrode sets for beam alignment 30-31 and 44-46 and stigmation 32 and 47, as well as aperture stops 28,29 and 42,43 and other standard elements.

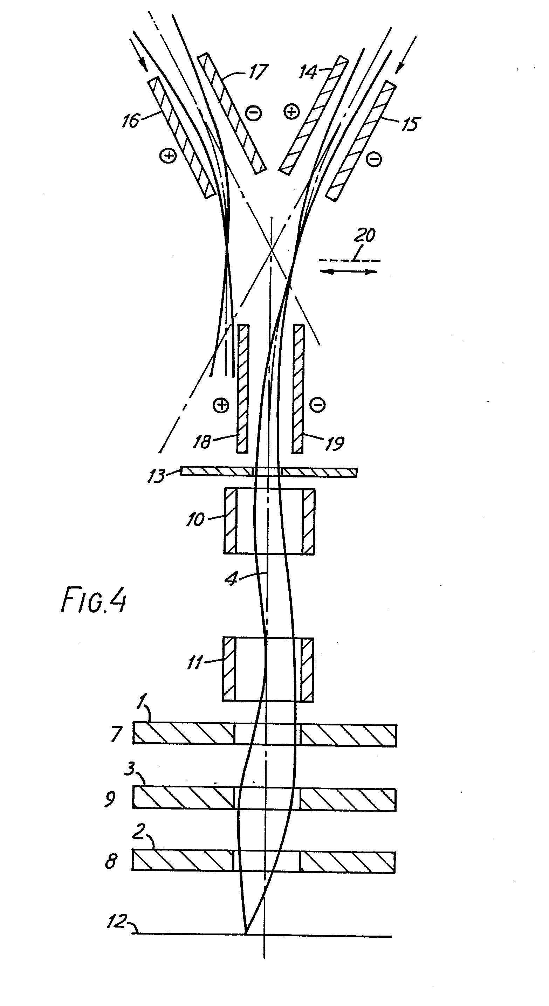

The deflecting prism system must select either the ion or the electron beam (or in some system variants must combine both beams) and pass it into the objective lens 1,2,3 without significantly distorting the beam in any way that would cause an increase in the diameter of the final beam focus. For this reason the prism is situated coincident with the beam crossover 7 that precedes the final lens and the prism structure is made symmetrical about that crossover. This is shown in detail in Figure 4 to which reference will now be made.

The prism system consists of three pairs of electrostatic deflector plates, one pair 14,15 on the axis of the incident ion beam, one pair 16,17 on the axis of the incident electron beam and one pair 18,19 on the axis 4 of the emergent beam. In the simplest mode of operation, the same potential is applied to one plate in each pair and a potential equal in magnitude but opposite in polarity to the other. Thus, in the example illustrated, the three plates 14,16,18 are positive and the three plates 15,17,19 are negative. Then, for a system in which the electron beam has been accelerated to a potential lower than that of the ion beam, the electrons will be deflected off the final axis by the deflector plate fields that direct the ions to the axis of the objective lens. The trajectories of the two beams are shown in Figure 4; that on the left is the electron beam, that on the right the ion beam. If the deflector plate potentials are reduced in magnitude, preserving proportionality between them, the electron beam can be selected in place of the ion beam. To facilitate setting up of the focal conditions (with an intermediate crossover symmetrically situated in the prism) an auxiliary focusing target 20 such as a fine-mesh copper grid can be inserted temporarily into the prism. For focusing, the grid may be imaged in several ways, including a shadow mode, by monitoring the transmitted beam current, and the collection of secondary electrons liberated by the impact of the beam on the grid.

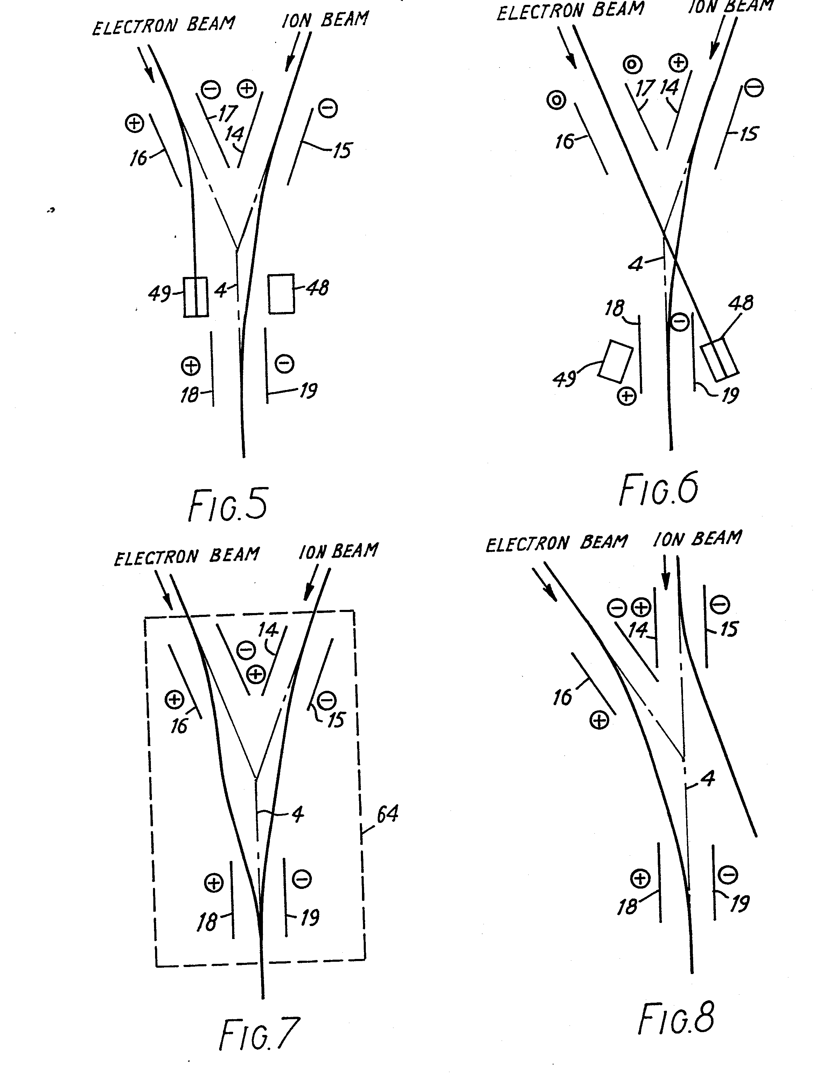

Some of the forms of prism that meet the general requirement of symmetry about a crossover for both the ion and the electron beam are shown in Figures 5 to 8. In Figure 5 is the configuration of Figure 4 in which equal positive potentials are applied to one plate of each deflector plate pair 14,16,18 and equal but opposite negative potentials applied to the other plates 15,17,19, but supplemented by an ion collector 48 and an electron collector 49 for monitoring the current in the non-selected beam. Figure 6 shows a similar arrangement but in which the upper plate pair 52,53 for the non-selected beam is grounded so that the beam passes undeflected into a collector 48,49 as appropriate.

In some applications the requirement is to superimpose ion and electron beams on the target. This can be achieved by using both electric and magnetic fields in the prism system: the electric fields deflect both the ions and the electrons, in opposite directions and to an extent dependent only on the accelerating potentials of the beams, whilst the magnetic field deflects the electrons much more strongly than the ions, because of the large difference between their mass-to-charge ratios. In Figure 7 is shown a combined magnetic and electric prism in which all particles are subject to the same fields, equal and opposite potentials being applied to the deflector plate pairs 58,59; 60,61; 62,63. The magnetic field is normal to the plane containing the two beams and is produced by a pair of polepieces whose extent is represented by dotted line 64. The electric field has the dominant effect on the ions and the magnetic field has a stronger effect than the electric field on the electrons, so that both beams emerge on the same axis. This scheme could be combined with superimposed magnetic and electric deflectors between the prism and the lens (in place of the solely electric deflectors 10,11), to permit independent and simultaneous scanning of the beams over the target.

A further variant is shown in Figure 8, in which the axis of one of the upper columns 5,6 (in this case the ion column axis) is coincident with the objective lens axis 4, but which preserves the symmetry of the system (for whichever beam is selected). Further versions of combining prism are possible which preserve symmetry, whilst related configurations can be produced if the requirements for symmetry or for the prism to be situated at a crossover in the beam are relaxed.

The system shown in Figure 3 utilises electric lenses, deflectors and stigmators in both of the upper columns. This is necessary for the ion column and is convenient for the electron column, although, in the latter, magnetic optical elements could have been employed. The convenience of using exclusively electric components is that if all the electrode supplies are linked (either by the use of potential-divider resistor chains or by indirect means), so that all the electrode potentials can be varied in the same ratio, the energy of a beam entering the prism can be adjusted without introducing changes to the focal and the deflection conditions. Only small trimming adjustments are needed to maintain constant currents from the cathode and from the ion source. With this arrangement there are three groups of high-voltage and associated electrical supplies: for the electrodes in the electron upper column, for the electrodes in the upper ion column, and for the objective lens alone. The prism supplies are linked to those for whichever upper column is to be selected. An exemplary setting-up procedure would be, in outline:

1.    Set up the ion source to produce an emergent beam at 60kV, so that the ions are brought to a focus at the focusing target situated at the point of symmetry in the prism system. The prism system would be energised so that the ions would be directed along the axis 4 of the objective lens.

2. Bring the ion beam to a focus at the final target, using the einzel-lens objective (whose central electrode 3 would be driven from a variable positive high-voltage supply completely independent of either of the upper column electrode supplies).

3. Set up the electron source to produce an emergent beam at 30kV, and the prism system to direct that beam along the axis 4 of the objective lens.

4. Vary the electron beam voltage and the prism system voltage until, with no change to the objective lens high voltage supply, the electron beam is brought to a focus at the target.

5. Carry out small adjustments iteratively, as necessary.

This presupposes that the ion beam is at the higher voltage, for which an arbitrary but representative value of 60kV has been assigned, but there would be no change of principle were the electron beam voltage to be, for example, higher; further, it neglects the further adjustments to maintain constant cathode current and the additional adjustments that would be needed for simultaneous production of both ion and electron beams.

The system described above may be utilised in a variety of different circumstances, for example:-

In microscopy and microanalysis, in which the ion and the electron beams are scanned over the surface of the target in order to generate information about it by means including the liberation of secondary and Auger electrons, the liberation of secondary ions, the generation of photons of visible light or of x-rays;

In microscopy and microanalysis, in which the ion beam is used to modify the target by sputtering material away so, for example, revealing buried features for examination in a scanning mode with either the ion or the electron beam;

In analysis where the target is the specimen in a transmission microscope configured so that the ion beam can be used to modify the specimen or to analyse whilst the electron beam serves to illuminate the specimen for imaging by a series of post-specimen lenses;

In microcircuit fabrication, in which the different interactions between the ion and electron beams are utilised, for example, in which the ion beam is used to modify the target (by exposure of a resist layer, by ion implantation, by a sputtering process or a chemically-assisted micromachining process, or by other means) whilst the electron beam is used, for example to detect registration marks that would not be detectable by the ion beam.

CLAIMS

1.      A charged-particle optical system for the production of finely-focused beams of both electrons and ions, said system comprising a source of electrons, a source of ions and a single electrostatic objective lens comprising at least two electrodes arranged along an optical axis, the lens electrode potentials and the energies of the particles entering the lens being such as to cause the lens to focus both the ion and electron beams onto a common target plane coincident with the target.

2.      An optical system as claimed in claim 1 wherein said objective lens has three or more electrodes spaced apart along the optical axis and wherein the outermost electrodes are at the same potential so that the particles emerge from the lens with the same energy as that which they possessed when they entered the lens, and the inner electrode or electrodes are at a higher or lower potential.

3.      An optical system as claimed in claim 1 wherein said objective lens has three or more electrodes spaced apart along the optical axis and wherein the outermost electrodes are at different potentials so that the particles are subjected to a net acceleration or deceleration as they pass through the lens.

4.      An optical system as claimed in either one of claims 2 or 3 wherein the objective lens is a three-element einzel lens.

5.      An optical system as claimed in any one of the preceding claims 1 further comprising a deflecting prism preceding the objective lens in the direction of motion of the particles and operable to combine the ion and electron beams from the respective sources.

6.      An optical system as claimed in claim 5 wherein said deflecting prism comprises means for generating magnetic and/or electric fields through which the respective beams pass, and means for controlling said field or fields in such a way as to direct either the electron beam, or the ion beam, or both in sequence or simultaneously into the objective lens.

7. An optical system as claimed in either one of claims 5 or 6 wherein the axes of the beams emerging from the electron and ion sources are arranged to cross in the region of said deflecting prism which latter is operable to deflect the two beams onto said optical axis for passage through the objective lens.

8. An optical system as claimed in any one of the preceding claims wherein each source comprises an electron gun or ion gun as appropriate together with a separate optical column incorporating a condenser lens or lenses.

9. An optical system as claimed in claim 8 wherein each optical column incorporates elements for control of beam alignment and stigmation.

10. An optical system as claimed in either one of claims 8 or 9 wherein each optical column incorporates a respective aperture stop.

11. An optical system as claimed in any one of claims 8 to 10 wherein the separate components of each of the sources are composed principally of electric elements supplied from a common or interlinked electrical power supply.

12. An optical system as claimed in any one of claims 8 to 11 when dependent upon claim 7 wherein the separate optical columns are such as to bring their respective beams to a focus within or in the immediate vicinity of the deflecting prism.

13 An optical system as claimed in any one of the preceding claims further including scanning means for causing the beam impinging on the target to be scanned thereacross.

14.    A charged-particle optical system as claimed in claim 1 substantially as hereinbefore described.

FIG.1

+60KV ⎯⎯⎯⎯⎯⎯⎯⎯⎯⎯⎯⎯⎯⎯⎯⎯⎯⎯⎯⎯⎯ 0

+

AXIAL
POTENTIAL
WITH
RESPECT 0
TO GROUND

ION ENERGY
(INCREASING)

ELECTRON
ENERGY
(INCREASING)

−30KV ⎯⎯⎯⎯⎯⎯⎯⎯⎯⎯⎯⎯⎯⎯⎯⎯⎯⎯⎯⎯⎯ 0

B

1  3  2

4

A

FIG.2

FIG.3

0150941

3/5

0150941

FIG.4

FIG.5

FIG.6

FIG.7

FIG.8

0150941

**European Patent Office**

**EUROPEAN SEARCH REPORT**

Application number

## DOCUMENTS CONSIDERED TO BE RELEVANT

EP 85300211.1

| Category | Citation of document with indication. where appropriate, of relevant passages | Relevant to claim | CLASSIFICATION OF THE APPLICATION (Int. Cl.4) |
|---|---|---|---|
| X | <u>US - A - 3 617 739</u> (LIEBL)<br><br>* Fig. 1-2; abstract; column 4, line 63 - column 5, line 23; claims 1,4-10 *<br><br>-- | 1-4 | H 01 J 37/10<br><br>H 01 J 27/00 |
| A | <u>EP - A2 - 0 003 659</u> (HITACHI)<br><br>* Fig.; abstract; page 3, line 27 - page 5, line 14; claims 1-2,3,6 *<br><br>-- | 1 | |
| A | <u>EP - A2 - 0 084 850</u> (HITACHI)<br><br>* Fig. 1-3; abstract; page 1, line 5 - page 3, line 20; page 5, lines 3-18; page 7, line 14 - page 8, line 12; page 9, lines 6-14; claims 1-2 *<br><br>---- | 1 | |

|  |  |
|---|---|
|  | **TECHNICAL FIELDS SEARCHED (Int. Cl.4)** |
|  | H 01 J 37/00<br><br>H 01 J 27/00<br><br>H 01 J 3/00<br><br>H 01 J 49/00 |

The present search report has been drawn up for all claims

| Place of search | Date of completion of the search | Examiner |
|---|---|---|
| VIENNA | 10-04-1985 | BRUNNER |

EPO Form 1503 03 82

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document